# FASCICULE DE BREVET EUROPEEN

(11) **EP 4 138 140 B1**
(45) Date de publication et mention de la délivrance du brevet: **29.10.2025**
(21) Numéro de dépôt: 22189371.2
(22) Date de dépôt: 09.08.2022
(51) Int. Cl.: H10K 59/65

(54) **PROCÉDÉ DE FABRICATION D'UN DISPOSITIF OPTOÉLECTRONIQUE**
VERFAHREN ZUR HERSTELLUNG EINER OPTOELEKTRONISCHEN VORRICHTUNG
METHOD FOR MANUFACTURING AN OPTOELECTRONIC DEVICE

(30) Priorité: 19.08.2021 FR 2108773; 28.10.2021 FR 2111478
(43) Date de publication de la demande: 22.02.2023
(73) Titulaire: Commissariat à l'Energie Atomique et aux Energies Alternatives, 75015 Paris (FR)
(72) Inventeur: TEMPLIER, François, 38054 GRENOBLE CEDEX 09 (FR); ESPIAU DE LAMAESTRE, Roch, 38054 GRENOBLE CEDEX 09 (FR); MAINDRON, Tony, 38054 GRENOBLE CEDEX 09 (FR)
(74) Mandataire: Cabinet Beaumont

(56) Documents cités:
- EP-A1- 3 624 192
- WO-A1-2017/089676
- WO-A1-2018/180577
- US-A1- 2018 226 595
- US-A1- 2021 036 060

## Description

### Domaine technique

La présente description concerne de façon générale le domaine des dispositifs optoélectroniques, et vise plus particulièrement un procédé de fabrication d'un dispositif optoélectronique combinant une fonction d'émission lumineuse et une fonction de capture optique.

### Technique antérieure

Diverses applications sont susceptibles de tirer profit d'un dispositif optoélectronique combinant une fonction d'émission lumineuse et une fonction de capture optique. Un tel dispositif peut par exemple être utilisé pour réaliser un écran d'affichage interactif.

### Résumé de l'invention

Un objet d'un mode de réalisation est de pallier tout ou partie des inconvénients des solutions connues pour réaliser un dispositif optoélectronique combinant une fonction d'émission lumineuse et une fonction de capture optique.

Pour cela, un mode de réalisation prévoit un procédé de fabrication d'un dispositif optoélectronique tel que décrit dans la revendication 1.

Selon un mode de réalisation, le procédé comprend la formation d'une pluralité de diodes photosensibles dans l'empilement actif de diode photosensible.

Selon un mode de réalisation, à l'étape a), l'empilement actif de diode photosensible est fixé sur le circuit intégré de contrôle par collage direct d'une couche diélectrique préalablement déposée sur l'empilement actif de diode photosensible, avec une couche diélectrique préalablement déposée sur le circuit intégré de contrôle.

Selon un mode de réalisation, le procédé comprend, après l'étape b), la formation de filtres optiques ou d'éléments de conversion de couleur au-dessus des diodes électroluminescentes organiques.

Selon un mode de réalisation, les diodes électroluminescentes organiques sont des diodes monochromatiques de même couleur, au moins une desdites diode électroluminescentes organiques étant surmontée d'un élément de conversion photoluminescent adapté à convertir la lumière émise par la diode vers une première longueur d'onde visible et au moins une autre desdites diode électroluminescentes organiques étant surmontée d'un élément de conversion photoluminescent adapté à convertir la lumière émise par la diode en un rayonnement lumineux dans la gamme de longueurs d'ondes détectée par ladite au moins une diode photosensible inorganique, de préférence un rayonnement infrarouge.

Selon un mode de réalisation, au moins une desdites diodes électroluminescentes organiques n'est pas surmontée par un élément de conversion photoluminescent.

Selon un mode de réalisation, les diodes électroluminescentes organiques sont adaptées à émettre majoritairement de la lumière bleue.

Selon un mode de réalisation, les éléments de conversion photoluminescents sont réalisés à base de boîtes quantiques ou de matériaux pérovskites.

Selon un mode de réalisation, l'empilement actif de diode photosensible comprend au moins une couche semiconductrice en un matériau III-V.

Selon un mode de réalisation, ladite étape de dopage de type P de portions localisées de la première couche est mise en oeuvre après l'étape a) et avant l'étape b).

Selon un mode de réalisation, le procédé comprend en outre, après ladite étape de dopage de type P de portions localisées de la première couche et avant l'étape b), une étape de formation de métallisations de connexion sur et en contact avec lesdites portions localisées de la première couche.

Selon un mode de réalisation, le procédé comprend, après l'étape b), une étape de fixation d'un substrat de support temporaire du côté d'une face du dispositif opposée au circuit intégré, suivie d'une étape de découpe de l'ensemble comportant le circuit intégré, l'empilement actif de diode photosensible et les diodes électroluminescentes organiques en une pluralité de puces élémentaires.

Selon un mode de réalisation, le procédé comprend en outre une étape de transfert et de fixation desdites puces élémentaire sur un substrat de report du dispositif, puis une étape de retrait du substrat de support temporaire.

Un mode de réalisation prévoit un dispositif optoélectronique tel que décrit dans la revendication 14.

Un autre mode de réalisation prévoit un système comportant un dispositif optoélectronique tel que défini ci-dessus, et une source lumineuse adaptée à émettre un rayonnement lumineux dans la gamme de longueurs d'ondes détectée par la diode photosensible inorganique, de préférence un rayonnement infrarouge.

Selon un mode de réalisation, la source lumineuse est une source déportée.

Selon un mode de réalisation, la source lumineuse est intégrée au dispositif optoélectronique et comprend au moins une diode électroluminescente organique de l'étage d'émission du dispositif optoélectronique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F, 1G, 1H et 1I sont des vues en coupe illustrant des étapes successives d'un exemple d'un procédé de fabrication d'un dispositif optoélectronique selon un mode de réalisation ;
les figures 2A, 2B, 2C, 2D, 2E, 2F, et 2G sont des vues en coupe illustrant d'autres étapes successives d'un exemple d'un procédé de fabrication d'un dispositif optoélectronique selon un mode de réalisation ;
la figure 3 représente de façon schématique un exemple d'un système comprenant un dispositif optoélectronique selon un mode de réalisation ; et
la figure 4 est une vue en coupe illustrant de façon schématique et partielle un autre exemple d'un dispositif optoélectronique selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des diodes photosensibles, des diodes électroluminescentes (LED) et des circuits intégrés de contrôle des dispositifs décrits n'a pas été détaillée, la réalisation détaillée de ces éléments étant à la portée de la personne du métier à partir des indications de la présente description. De plus, les diverses applications que peuvent avoir les dispositifs décrits n'ont pas détaillées, les modes de réalisation décrits étant compatibles avec toutes ou la plupart des applications susceptibles de tirer profit d'un dispositif combinant une fonction d'émission lumineuse et une fonction de capture optique (photodétection).

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures correspondantes.

Sauf précision contraire, les expressions "environ", "approximativement", "sensiblement", et "de l'ordre de" signifient à 10 % près, de préférence à 5 % près.

Selon un aspect d'un mode de réalisation, on prévoit, pour réaliser un dispositif optoélectronique combinant une fonction d'émission lumineuse et une fonction de photodétection, de reporter un empilement actif de diode photosensible inorganique sur un circuit intégré de contrôle préalablement formé dans et sur un substrat semiconducteur, puis de former une pluralité de LED organiques sur l'empilement actif de diode photosensible. Le procédé comprend en outre, après le report de l'empilement actif de diode photosensible inorganique et avant la formation des LED organiques, la formation de vias conducteurs traversant l'empilement de diode photosensible, permettant de connecter électriquement l'empilement actif de diode photosensible et les LED organiques au circuit intégré de contrôle.

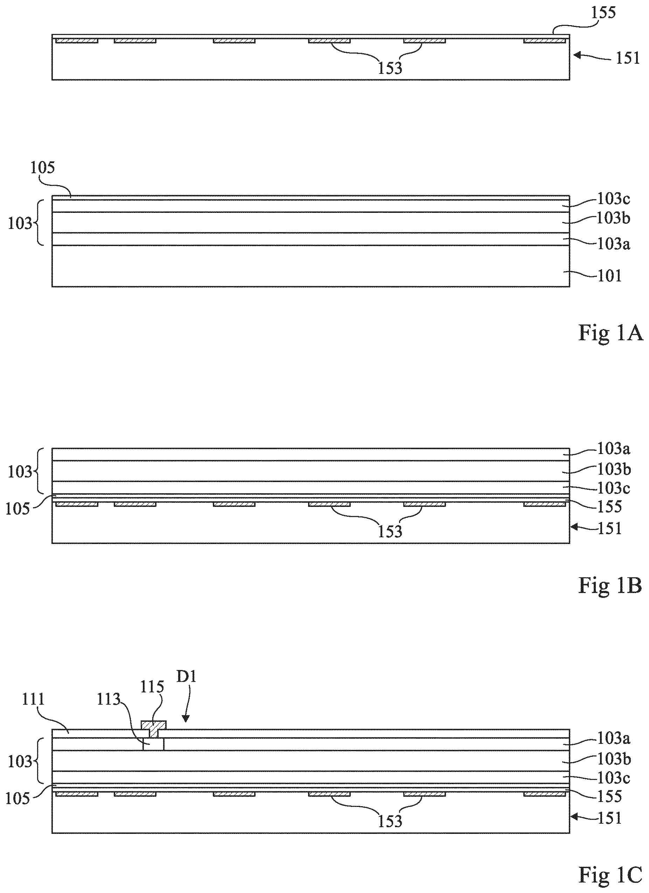

Les figures 1A à 1I sont des vues en coupe illustrant des étapes successives d'un exemple, non limitatif, de mise en oeuvre d'un tel procédé. Diverses variantes sont à la portée de la personne du métier à partir des indications de la présente description.

Par souci de simplification, on a représenté sur les figures 1A à 1I la réalisation d'un dispositif comportant une unique diode photosensible D1 et trois LED organiques L1, L2, L3. En pratique, les procédés décrits peuvent bien entendu être utilisés pour réaliser des dispositifs comportant un nombre beaucoup plus important de diodes photosensibles et de LED organiques.

La figure 1A illustre très schématiquement, en partie supérieure, un circuit intégré de contrôle 151 formé dans et sur un substrat semiconducteur, par exemple un substrat en silicium monocristallin. Le circuit intégré 151 comprend des circuits de contrôle et de lecture des LED et des diodes photosensibles du dispositif. A titre d'exemple, le circuit intégré 151 comprend un ensemble de cellules élémentaires de contrôle et de lecture, permettant de contrôler individuellement chaque LED et de lire individuellement chaque diode photosensible du dispositif. Le circuit intégré 151 est par exemple un circuit CMOS (de l'anglais "Complementary Metal Oxide Semiconductor" - métal oxyde semiconducteur complémentaire). Dans cet exemple, le circuit 151 comprend une pluralité de plots métalliques de connexion 153 disposés du côté de sa face supérieure, destinés à être connectés respectivement aux anodes et cathodes des LED et des diodes photosensibles du dispositif. A titre d'exemple, les plots 153 affleurent du côté de la face supérieure d'un empilement d'interconnexion (non détaillé sur la figure) revêtant la face supérieure du substrat semiconducteur du circuit.

La figure 1A illustre en outre schématiquement, en partie inférieure, la structure obtenue à l'issue d'étapes de formation d'un empilement actif de diode photosensible 103 sur la face supérieure d'un substrat 101.

L'empilement 103 est un empilement de couches semiconductrices inorganiques. L'empilement 103 comprend par exemple une ou plusieurs couches en un matériau semiconducteur de type III-V. L'empilement 103 est par exemple un empilement actif de photodiode sensible dans l'infrarouge ou le proche infrarouge. A titre de variante, l'empilement 103 est un empilement actif de photodiode sensible dans le visible. A titre d'exemple, l'empilement 103 comprend, dans l'ordre à partir de la face supérieure du substrat 101, une couche 103a en phosphure d'indium (InP) non intentionnellement dopé, une couche d'absorption 103b en arséniure d'indium-gallium (InGaAs), par exemple intrinsèque ou faiblement dopé de type N (par exemple de l'ordre de 10¹⁵ atomes/cm³), et une couche 103c en phosphure d'indium (InP) dopé de type N. A titre d'exemple, le niveau de dopage de type N de la couche 103c est compris entre 10¹⁶ et 10¹⁸ atomes/cm³. Dans cet exemple, la couche 103b est en contact, par sa face inférieure, avec la face supérieure de la couche 103a, et la couche 103c est en contact, par sa face inférieure, avec la face supérieure de la couche 103b.

Le substrat 101 est par exemple en phosphure d'indium. Les couches 103a, 103b et 103c peuvent être formées successivement par épitaxie sur la face supérieure du substrat 101. Le substrat 101 est alors un substrat de croissance. Une couche tampon, non représentée, par exemple en phosphure d'indium, peut éventuellement faire interface entre le substrat 101 et la couche 103a. La couche tampon est par exemple en contact, par sa face inférieure, avec la face supérieure du substrat 101, et, par sa face supérieure, avec la face inférieure de la couche 103a. La couche tampon peut également être formée par épitaxie à partir de la face supérieure du substrat 101, avant la formation des couches 103a, 103b et 103c.

A titre de variante, plutôt que de former l'empilement actif de diode photosensible 103 par épitaxie sur la face supérieure du substrat 101, l'empilement actif peut être formé dans l'ordre inverse sur un substrat de croissance, non représenté, puis reporté et fixé sur le substrat 101. Dans ce cas, les couches 103c, 103b et 103a sont successivement formées par épitaxie sur une face du substrat de croissance. Une couche tampon, par exemple en phosphure d'indium, peut éventuellement faire interface entre le substrat de croissance et la couche 103c. L'empilement 103 est ensuite fixé sur la face supérieure du substrat 101, par exemple par collage direct ou collage moléculaire de la face inférieure de la couche 103a sur la face supérieure du substrat 101. Le substrat de croissance, et, le cas échéant, la couche tampon faisant interface entre le substrat de croissance et la couche 103c, peuvent ensuite être retirés de façon à libérer l'accès à la face supérieure de la couche 103c. Dans cette variante, le substrat 101 est un substrat de support, par exemple en silicium, ou en tout autre matériau adapté à servir de support de réception de l'empilement actif 103.

A ce stade, chacune des couches de l'empilement actif de diode photosensible 103 s'étend par exemple de façon continue et avec une épaisseur sensiblement uniforme sur toute la surface supérieure du substrat 101.

La figure 1A illustre en outre une étape de dépôt d'une couche diélectrique 155, par exemple en oxyde de silicium, sur et en contact avec la face supérieure du circuit intégré de contrôle 151. Dans cet exemple, la couche 155 s'étend de façon continue et avec une épaisseur sensiblement uniforme sur toute la surface supérieure du circuit intégré de contrôle 151.

La figure 1A illustre de plus une étape de dépôt d'une couche diélectrique 105, par exemple en le même matériau que la couche 155, par exemple en oxyde de silicium, sur la face supérieure de l'empilement actif de diode photosensible 103. A titre d'exemple, la couche 105 est déposée sur et en contact avec la face supérieure de la couche 103c. La couche 105 s'étend par exemple de façon continue et avec une épaisseur sensiblement uniforme sur toute la surface supérieure de l'empilement 103.

La figure 1B illustre la structure obtenue à l'issue d'une étape de report et de fixation de l'empilement actif de diode photosensible 103 sur le circuit intégré de contrôle 151, puis de retrait du substrat 101. Lors de cette étape, l'empilement actif de diode photosensible 103 est reporté sur le circuit intégré 151, en utilisant le substrat 101 comme poignée de support. Sur la figure 1B, la structure comportant le substrat 101 et l'empilement 103 est retournée par rapport à l'orientation de la figure 1A. L'empilement 103 est ensuite fixé sur le circuit intégré de contrôle 151. Dans cet exemple, l'empilement 103 est fixé par collage direct ou collage moléculaire de la face inférieure (dans l'orientation de la figure 1B, correspondant à la face supérieure dans l'orientation de la figure 1A) de la couche 105, sur la face supérieure de la couche 155. Le substrat 101 est ensuite retiré, par exemple par meulage et/ou gravure chimique, de façon à libérer l'accès à la face supérieure de la couche 103a. A ce stade, chacune des couches de l'empilement actif de diode photosensible 103 s'étend par exemple de façon continue et avec une épaisseur sensiblement uniforme, sur toute la surface du circuit intégré de contrôle 151. On notera que dans cet exemple, l'empilement actif 103 est non structuré et n'a subi aucune étape de traitement localisé avant l'étape de report. Ainsi, l'étape de report ne requiert pas d'alignement précis.

La figure 1C illustre la structure obtenue à l'issue des étapes successives suivantes :
i) dépôt d'une couche diélectrique 111, par exemple en nitrure de silicium ou en oxyde de silicium, sur la face supérieure de la couche 103a, par exemple en contact avec la face supérieure de la couche 103a ;
ii) formation d'ouvertures traversantes localisées dans la couche diélectrique 111, en vis-à-vis de futures zones de reprise de contact de type P correspondant à des régions d'anode des diodes photosensibles du dispositif ;
iii) dopage de type P de régions localisées 113 de la couche 103a, situées en vis-à-vis desdites ouvertures traversantes ;
iv) formation de métallisations de reprise de contact 115 dans les ouvertures traversantes, chaque métallisation 115 venant contacter individuellement la région dopée de type P 113 sous-jacente, à travers l'ouverture correspondante.

A l'étape i), la couche diélectrique 111 est par exemple déposée par un procédé de dépôt chimique en phase vapeur assisté par plasma (PECVD).

A l'étape ii), les ouvertures traversantes formées dans la couche diélectrique 111 sont par exemple formées par photolithographie et gravure.

A l'étape iii), le dopage des régions 113 peut être réalisé par diffusion ou implantation d'éléments dopants de type P, par exemple du zinc (Zn) ou du béryllium (Be), en vis-à-vis des ouvertures formées à l'étape ii). Un recuit d'activation des éléments dopants peut ensuite être mis en oeuvre. A titre d'exemple, le recuit d'activation peut être un recuit laser superficiel, ce qui permet de ne pas altérer le circuit intégré 151 ni la qualité du collage entre le circuit intégré 151 et l'empilement actif de diode photosensible 103. Les régions dopées de type P 113 forment des régions d'anode des diodes photosensibles du dispositif. Dans cet exemple, les régions 113 s'étendent sur toute l'épaisseur de la couche 103a, et viennent en contact, par leur face inférieure, avec la face supérieure de la couche d'absorption 103b.

A l'étape iv), à titre d'exemple, une couche métallique est d'abord déposée de façon continue sur toute la surface supérieure de la structure, c'est-à-dire sur et en contact avec la face supérieure de la couche diélectrique 111 et dans les ouvertures formées à l'étape ii), puis retirée par photolithographie et gravure en conservant les métallisations 115. Dans cet exemple, chaque métallisation 115 constitue une électrode d'anode d'une diode photosensible D1 du dispositif.

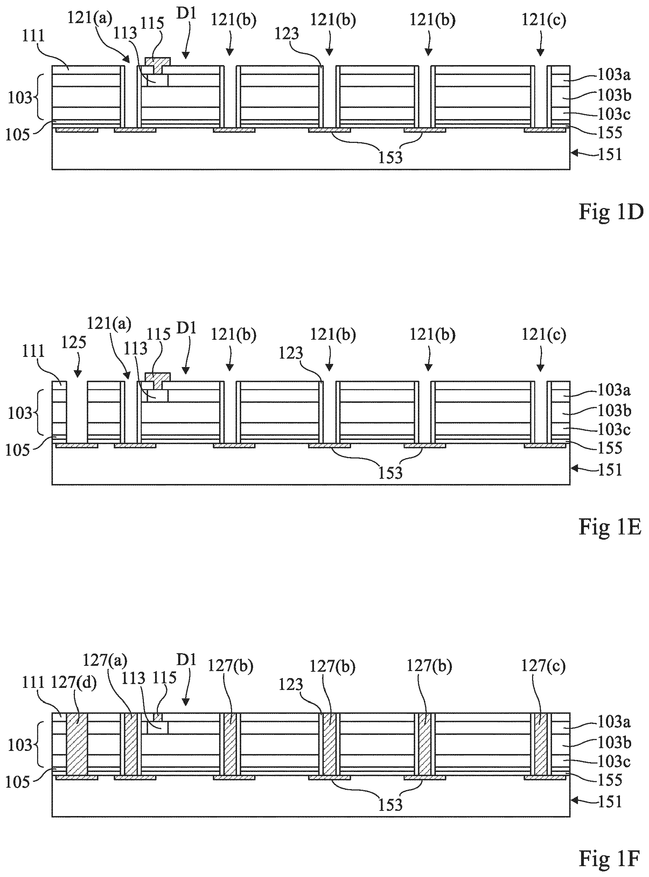

La figure 1D illustre la structure obtenue à l'issue d'une étape de formation, à partir de la face supérieure de la structure, de premières ouvertures ou vias de reprise de contact 121 traversant l'empilement actif de diode photosensible 103 et débouchant sur des plots de connexion 153 du circuit intégré de contrôle. Les ouvertures 121 s'étendent verticalement depuis la face supérieure de la couche diélectrique 111 jusqu'à la face supérieure des plots 153, à travers les couches 111, 103a, 103b, 103c, 105 et 155. Les ouvertures 121 ont par exemple une forme circulaire. Dans cet exemple, on vient former à cette étape, pour chacune des diodes photosensibles D1, une ouverture 121(a) spécifique formant une ouverture de reprise de contact d'anode de la diode. On vient en outre former, pour chacune des LED L1, L2, L3, une ouverture 121(b) spécifique formant une ouverture de reprise de contact d'anode de la LED. De plus, dans cet exemple, on vient former à cette étape, par exemple dans une région périphérique du dispositif, une ouverture 121(c) commune aux LED L1, L2, L3, formant une ouverture de reprise de contact de cathode desdites LED. Les ouvertures 121(a), 121(b), 121(c) sont par exemple identiques aux dispersions de fabrication près. Dans cet exemple, les ouvertures 121(a), 121(b), 121(c) sont formées simultanément lors d'une même étape de gravure localisée. Les ouvertures 121(a), 121(b), 121(c) débouchent respectivement sur des plots métalliques 153 distincts du circuit intégré de contrôle 151, de façon à permettre la commande individuelle des diodes D1, L1, L2, L3 par le circuit 151.

La figure 1D illustre en outre une étape de dépôt d'une couche électriquement isolante 123, par exemple en oxyde de silicium, sur les parois latérales des ouvertures 121(a), 121(b), 121(c). La couche 123 est par exemple d'abord déposée de façon continue sur toute la surface supérieure de la structure après la formation des ouvertures 121. Les portions horizontales de la couche 123 sont ensuite retirées par gravure anisotrope verticale de façon que seules subsistent les portions verticales revêtant les parois latérales des ouvertures 121.

La figure 1E illustre la structure obtenue à l'issue d'une étape ultérieure de formation, à partir de la face supérieure de la structure de la figure 1D, d'au moins une deuxième ouverture de reprise de contact 125 traversant l'empilement actif de diode photosensible 103 et débouchant sur un plot de connexion 153 du circuit intégré de contrôle. De même que les ouvertures 121, l'ouverture 125 s'étend verticalement depuis la face supérieure de la couche diélectrique 111 jusqu'à la face supérieure du plot 153 sous-jacent, à travers les couches 111, 103a, 103b, 103c, 105 et 155. L'ouverture 125 a par exemple la même forme que les ouvertures 121. Dans cet exemple, on vient former à cette étape, par exemple dans une région périphérique du dispositif, une ouverture 125 commune aux diodes photosensibles D1 du dispositif, formant une ouverture de reprise de contact de cathode desdites diodes.

A la différence des ouvertures 121, les parois latérales de l'ouverture 125 ne sont pas revêtues par une couche électriquement isolante.

La figure 1F illustre une étape ultérieure de remplissage des ouvertures 121(a), 121(b), 121(c) et 125 par du métal, de façon à former des vias conducteurs 127(a), respectivement 127(b), respectivement 127(c), respectivement 127(d). A l'issue de cette étape, une étape de planarisation de la face supérieure de la structure, par exemple une planarisation mécano-chimique (CMP), peut être mise en oeuvre, de sorte que les métallisation 115, 127 (a), 127 (b), 127(c), 127(d) affleurent au niveau de la face supérieure de la couche diélectrique 111.

Dans cet exemple, les vias 127(a) de reprise de contact d'anode des diodes D1, 127(b) de reprise de contact d'anode des LED L1, L2, L3 et 127(c) de reprise de contact de cathode des LED L1, L2, L3, sont isolés des couches de l'empilement 103 par la couche d'isolation latérale 123. Le via 127(d) de reprise de contact de cathode des diodes D1 est en revanche en contact, par ses flancs, avec les couches semiconductrices de l'empilement 103.

Le via 127(d) connecte électriquement la couche de cathode 103c de l'empilement de diode photosensible à un plot 153 de connexion de cathode des diodes photosensibles D1. On notera que dans la mesure les couches 103b et 103a de l'empilement 103 sont peu ou pas dopées, le contact latéral entre le via 127(d) et lesdites couches 103b, 103c n'entraine pas de court-circuit des diodes D1. La couche dopée 103c assure l'équipotentielle sur toute la surface du dispositif.

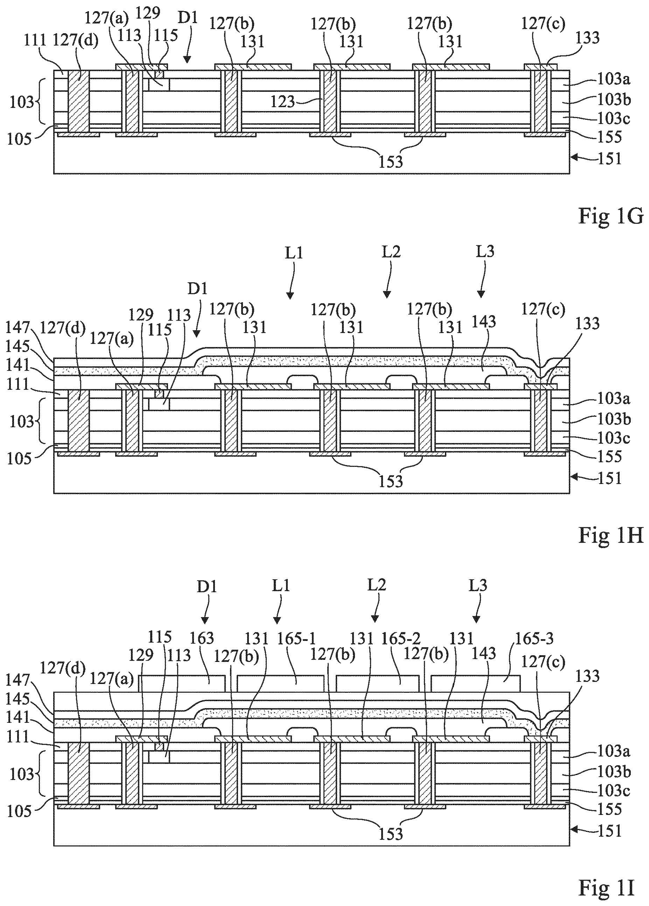

La figure 1G illustre la structure obtenue à l'issue d'une étape de formation de métallisations sur la face supérieure de la structure de la figure 1F. Les métallisations formées à cette étape sont en contact, par leur face inférieure, avec la face supérieure de la couche diélectrique 111 et avec des métallisations 127 ou 115 sous-jacentes.

A cette étape, on forme par exemple, pour chaque diode D1, une métallisation 129 connectant électriquement le via de reprise de contact d'anode 127(a) de la diode D1 à la métallisation de contact d'anode 115 de cette diode.

De plus, dans cet exemple, on forme, pour chaque LED L1, L2, L3, une métallisation 131 s'étendant sensiblement sur toute la surface de la LED, correspondant à une électrode d'anode de la future LED, en contact, par sa face inférieure, avec un via de reprise de contact d'anode 127(b) de la LED.

De plus, dans cet exemple, on forme une métallisation 133 de reprise de contact de cathode des LED, en contact, par sa face inférieure, avec le via de reprise de contact de cathode 127(c) des LED.

Les métallisations 129, 131 et 133 sont par exemple formées dans un même niveau métallique. A titre d'exemple, une couche de métal est d'abord déposée pleine plaque sur toute la surface supérieure de la structure de la figure 1F, puis retirée localement par photolithographie et gravure en conservant les métallisations 129, 131 et 133.

La figure 1H illustre la structure obtenue à l'issue d'étapes de formation des LED organiques L1, L2, L3 sur la face supérieure de la structure de la figure 1G.

Dans cet exemple, le procédé de formation des LED organiques comprend les étapes successives suivantes :
i) dépôt d'une couche de passivation 141 sur la face supérieure de la structure de la figure 1G, puis ouverture localisée de la couche 141 en vis-à-vis des métallisations 131 et 133 ;
ii) dépôt d'une couche active de diode organique 143 (constituée par exemple d'un empilement de couches d'injection, de transport et d'émission) sur et en contact avec les électrodes d'anode 131 des LED L1, L2, L3 ;
iii) dépôt d'une électrode de cathode 145 des LED L1, L2, L3 sur et en contact avec la face supérieure de la couche active 143 ; et
iv) dépôt d'une couche d'encapsulation 147 sur et en contact avec la face supérieure de l'électrode 145.

La couche 141 déposée à l'étape i) est par exemple une couche en un matériau polymère, par exemple une résine. A titre de variante, la couche 141 peut être en oxyde de silicium. La couche 141 peut être déposée pleine plaque, sur toute la surface supérieure de la structure de la figure 1G, puis retirée localement, par exemple par photolithographie et gravure, pour exposer les électrodes 131 et 133. Dans cet exemple, les métallisations 127(d) et 129 restent recouvertes par la couche 141. De plus, dans cet exemple, les portions exposées de la couche diélectrique 111 sont entièrement recouvertes par la couche 141. Plus particulièrement, dans cet exemple, en vue de dessus, chacune des métallisations 133 et 135 est entièrement entourée et séparée latéralement des autres métallisations par des portions de la couche 141.

La couche active 143 peut comprendre une couche unique en un matériau organique photosensible, ou un empilement de plusieurs couches organiques formant une couche photosensible. Dans cet exemple, la couche 143 est une couche à émission large spectre, par exemple une couche d'émission de lumière blanche. Dans cet exemple, la couche 143 est non pixellisée, c'est-à-dire qu'elle s'étend de façon continue en vis-à-vis des électrodes d'anode 133 des LED L1, L2, L3 du dispositif. Dans l'exemple représenté, la couche 143 ne s'étend pas en vis-à-vis des diodes photosensibles D1 du dispositif. A titre d'exemple, la couche active 143 peut être déposée de façon localisée par évaporation au travers d'un masque ou pochoir ("shadow mask" en anglais). Les trois couleurs sont alors déposées séparément et successivement et il n'y a pas besoin de prévoir de filtres colorés. A titre de variante, la couche 143 peut s'étendre de façon continue sur sensiblement toute la surface du dispositif, et en particulier en vis-à-vis des diodes photosensibles D1. Dans ce cas, la couche 143 peut être déposée pleine plaque, par exemple à la tournette ("spin coating" en anglais) . De préférence, la couche 143 ne recouvre pas l'électrode 133 de reprise de contact de cathode des LED.

L'électrode de cathode 145 s'étend par exemple de façon continue sur toute la face supérieure du dispositif. L'électrode 145 est de préférence en un matériau conducteur transparent, par exemple en un oxyde conducteur transparent, par exemple de l'oxyde d'indium-étain (ITO). En périphérie du dispositif, l'électrode 145 est en contact, par sa face inférieure, avec la face supérieure de l'électrode 133 de reprise de contact de cathode des LED.

La couche d'encapsulation 147 vise à protéger la couche active de LED 143, notamment contre l'humidité et l'oxygène. La couche 147 est de préférence en un matériau transparent électriquement isolant, par exemple en oxyde d'aluminium. La couche 147 s'étend par exemple de façon continue sur toute la surface supérieure du dispositif. Elle peut être réalisée par dépôt de couches minces atomiques (ALD - Atomic Layer Deposition en anglais).

La figure 1I illustre la structure obtenue à l'issue d'étapes de formation d'éléments de filtrage et/ou de conversion de couleur sur la face supérieure de la structure de la figure 1H.

A titre d'exemple, une couche planarisante 151 en un matériau transparent, par exemple en résine, est d'abord déposée sur la face supérieure de la structure de la figure 1H. Dans cet exemple, la couche 151 est en contact, par sa face inférieure, avec la face supérieure de la couche d'encapsulation 147. La couche 151 présente une face supérieure sensiblement plane.

Dans cet exemple, on vient former un filtre optique 163 en vis-à-vis de la diode photosensible D1, et des filtres optiques 165-1, 165-2, 165-3, en vis-à-vis respectivement des LED L1, L2 et L3. Le filtre 163 est par exemple adapté à couper le rayonnement visible et à laisser passer majoritairement un rayonnement infrarouge. On notera que le filtre 163 peut être remplacé par ou combiné avec un élément optique de mise en forme de la lumière incidente, par exemple une microlentille. Les filtres 165-1, 165-2, 165-3, sont par exemple adaptés à laisser passer majoritairement des rayonnements visibles dans respectivement trois gammes de longueurs d'onde distinctes. A titre d'exemple, les filtres 165-1, 165-2, 165-3 sont adaptés à laisser majoritairement de la lumière rouge, de la lumière verte et de la lumière bleue. Les filtres 163, 165-1, 165-2, 165-3 sont par exemple des filtres en résine. A titre de variante, les filtres 165-1, 165-2, 165-3 peuvent être remplacés par des éléments de conversion de couleur photoluminescents. A titre d'exemple, la couche active 143 est une couche d'émission monochromatique, par exemple une couche d'émission de lumière bleue. Dans ce cas, les éléments 165-1 et 165-2 sont par exemple respectivement un élément de conversion photoluminescent adapté à convertir la lumière bleue émise par la couche active 143 en lumière rouge, et un élément de conversion photoluminescent adapté à convertir la lumière bleue émise par la couche active 143 en lumière verte. Dans cette configuration, l'élément 165-3 peut quant à lui être omis. Les LED L1, L2 et L3 définissent ainsi trois pixels d'émission adaptés à émettre respectivement de la lumière rouge, de la lumière verte et de la lumière bleue.

Ainsi, on obtient un dispositif comportant un ou plusieurs pixels de détection comportant chacun une diode photosensible D1 à base d'un matériau semiconducteur inorganique, et un ou plusieurs pixels d'émission comportant chacun une LED organique L1, L2, L3, l'ensemble des pixels de détection et d'émission étant commandé par un même circuit intégré de contrôle.

On notera que, dans l'exemple décrit ci-dessus, la couche active organique 143 est commune aux différents pixels émissifs du dispositif, la différentiation des couleurs étant assurée par des filtres ou éléments de conversion de couleurs en vis-à-vis des LED organiques des différents pixels. A titre de variante, des couches actives organiques de natures distinctes peuvent être prévues dans les LED organiques des différents pixels, de façon à réaliser des LED L1, L2, L3 émettant directement dans des gammes de longueurs d'ondes distinctes. Dans ce cas, les filtres 165-1, 165-2, 165-3 peuvent être omis.

Par ailleurs, les modes de réalisation décrits ne se limitent pas à l'exemple particulier décrit ci-dessus d'un dispositif comportant trois types de pixels émissifs distincts adaptés à émettre respectivement dans trois gammes de longueurs d'ondes distinctes. A titre de variante, le dispositif peut comporter deux ou plus de quatre pixels émissifs émettant respectivement dans des gammes de longueurs d'ondes distinctes. Dans une autre variante, le dispositif peut être monochromatique en émission, c'est-à-dire comporter un unique type de pixel émissif. Dans ce cas, les filtres ou éléments de conversion de couleur 165-1, 165-2, 165-3 peuvent être omis.

En outre, dans l'exemple décrit ci-dessus, le dispositif est monochromatique en réception, c'est-à-dire qu'il comprend un unique type de pixel de détection, sensible dans une gamme de longueur d'onde déterminée. A titre de variante, le dispositif peut comprendre plusieurs types de pixels de détection adaptés à mesurer des rayonnements dans des gammes de longueurs d'ondes distinctes. La différentiation des gammes de longueurs d'onde peut alors être assurée par des filtres 163 de natures distinctes en vis-à-vis des différents pixels de détection. Dans une autre variante, les filtres optiques 163 peuvent être omis dans le cas d'un dispositif monochromatique en réception.

Par ailleurs, dans l'exemple décrit ci-dessus, le via de reprise de contact de cathode 127(d) des diodes photosensibles D1 est commun aux différentes diodes D1. A titre de variante, le dispositif peut comprendre un via de reprise de contact de cathode 127(d) spécifique par diode photosensible D1.

De façon similaire, dans l'exemple décrit ci-dessus, l'électrode de cathode 145 et le via de reprise de contact de cathode 127(c) sont commun aux différentes LED L1, L2, L3 du dispositif. A titre de variante, le dispositif peut comprendre une électrode de cathode 145 spécifique et/ou un via de reprise de contact de cathode 127(c) spécifique par LED.

Dans une autre variante, un via de reprise de contact de cathode unique, commun aux LED et aux diodes photosensibles du dispositif, peut être prévu en périphérie du dispositif, les électrodes de cathode des LED et des diodes photosensibles étant alors connectées entre elles.

Le procédé décrit en relation avec les figures 1A à 1I peut être utilisé pour réaliser des micro-écrans monolithiques, combinant une fonction d'affichage d'images et une fonction de capture optique, par exemple pour réaliser un écran interactif adapté à mettre en oeuvre des fonctions de reconnaissance de visage ou de formes, de détection de mouvement, d'identification, etc. Un avantage du procédé décrit est qu'il permet de réaliser des pixels d'affichage et des pixels de capture de petites dimensions latérales, et ainsi obtenir des résolutions d'affichage et des résolutions de capture élevées. On notera que dans l'exemple décrit ci-dessus, le dispositif comprend des macro-pixels comprenant chacun un pixel de détection et trois pixels d'émission adaptés à émettre respectivement dans trois gammes de longueurs d'ondes distinctes. Autrement dit, la résolution du dispositif en émission et la résolution du dispositif en réception sont identiques. A titre de variante, la résolution du dispositif d'affichage et la résolution du capteur optique peuvent être différentes. En particulier, le nombre de pixels de détection peut être inférieur au nombre de pixels d'émission d'une même gamme de longueurs d'ondes.

A titre de variante, le procédé décrit en relation avec les figures 1A à 1I peut être utilisé pour réaliser des dispositifs d'affichage interactifs de plus grandes dimensions, par exemple un écran de télévision, d'ordinateur, de smartphone, de tablette numérique, etc. Un tel dispositif peut comporter une pluralité de puces électroniques élémentaires disposées, par exemple selon un agencement matriciel, sur un même substrat de report. Les puces élémentaires sont montées solidaires du substrat de report et connectées à des éléments de connexion électrique du substrat de report pour leur commande. Chaque puce comporte une ou plusieurs LED L1, L2, L3, une ou plusieurs diodes photosensibles D1, et un circuit 151 de commande de ladite une ou plusieurs LED et de ladite une ou plusieurs diodes photosensibles. Chaque puce correspond par exemple à un macro-pixel du dispositif. A titre d'exemple, chaque puce comprend trois LED L1, L2, L3 commandables individuellement, définissant respectivement trois pixels d'émission adaptés à émettre respectivement de la lumière rouge, de la lumière verte et de la lumière bleue, et une diode photosensible D1 adaptée à détecter un rayonnement infrarouge ou proche infrarouge, définissant un pixel de détection.

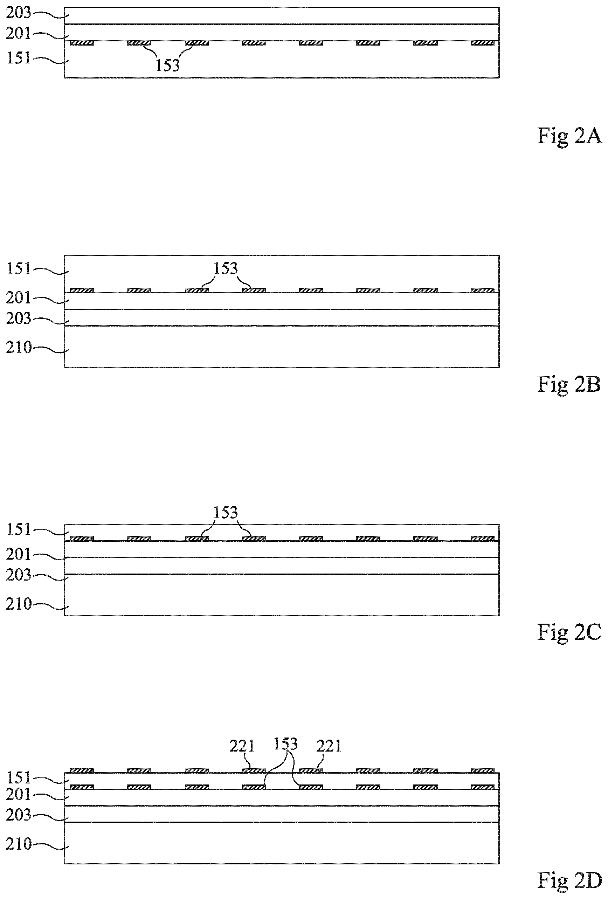

Les figures 2A à 2G sont des vues en coupe illustrant des étapes successives d'un exemple d'un procédé de fabrication d'un tel dispositif.

La figure 2A illustre de façon très schématique une structure de départ qui correspond à une structure du type obtenue par le procédé des figures 1A à 1I, comprenant un étage de circuit intégré de contrôle 151, surmonté d'un étage de photo-détection 201, lui-même surmonté d'un étage d'émission 203. L'étage de photo-détection 201 comprend une pluralité de diodes photosensibles D1 (non détaillées sur les figures 2A à 2G) commandables individuellement par le circuit intégré 151. L'étage d'émission comprend une pluralité de LED L1, L2, L3 (non détaillées sur les figures 2A à 2G) commandables individuellement par le circuit intégré 151. Sur la figure 2A, seuls les plots de connexion électrique 153 du circuit intégré 151, disposés du côté de la face supérieure du circuit intégré 151, ont été détaillés.

La figure 2B illustre une étape de collage de la structure de la figure 2A sur un substrat de support temporaire 210, par exemple en silicium. La structure de la figure 2A est fixée au substrat de support 210 par sa face opposée au circuit intégré de contrôle 151, c'est-à-dire par sa face inférieure dans l'orientation de la figure 2B, correspondant à sa face supérieure dans l'orientation de la figure 2A.

La figure 2C illustre une étape optionnelle d'amincissement du substrat semiconducteur du circuit intégré 151, par sa face opposée aux étages 201 et 203. A titre d'exemple, le circuit intégré 151 est initialement formé dans et sur un substrat de type SOI (de l'anglais "Semiconductor On Insulator" - semiconducteur sur isolant). Le substrat SOI comprend par exemple un support en silicium, revêtu d'une couche isolante, elle-même revêtue d'une couche de silicium monocristallin (non détaillés sur les figures). Les composants, notamment des transistors, du circuit intégré 151, peuvent être formés dans et sur la couche de silicium monocristallin du substrat SOI. L'étape d'amincissement de la figure 2C peut consister à retirer le substrat de support du substrat SOI, de façon à ne conserver que la couche de silicium monocristallin et la couche isolante du substrat SOI.

A titre de variante, le circuit intégré 151 est formé dans et sur un substrat massif de silicium, l'étape d'amincissement pouvant alors consister à réduire l'épaisseur du substrat, par exemple par meulage, à partir de sa face supérieure (dans l'orientation de la figure 2C). Une couche isolante de passivation (non détaillée sur la figure) peut ensuite être déposée sur la face supérieure du substrat aminci.

La figure 2D illustre une étape de formation, du côté de la face supérieure du circuit intégré 151, de plots métalliques de connexion 221, reliés aux plots de connexion 153 et/ou à des bornes de connexion de composants électroniques, par exemple des transistors MOS, du circuit intégré 151, par l'intermédiaire de vias conducteurs non détaillés sur la figure, traversant le substrat semiconducteur du circuit intégré 151. Les plots 221 étant pour l'essentiel reliés à des bornes de connexion à l'intérieur du circuit, leur nombre est en pratique supérieur au nombre de plots 153.

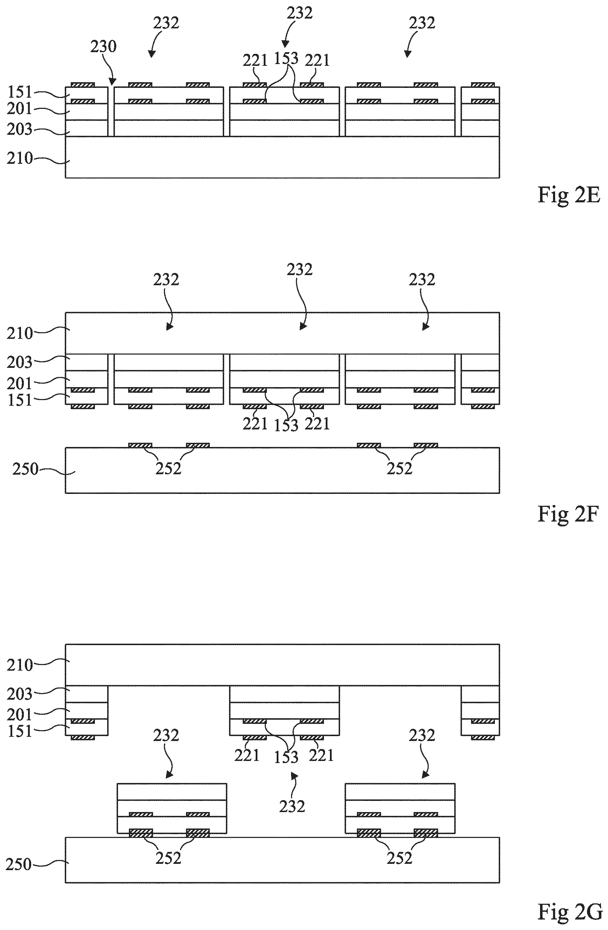

La figure 2E illustre une étape de formation, à partir de la face supérieure du circuit intégré 151, de tranchées 230 traversant verticalement le circuit intégré 151, l'étage de détection 201 et l'étage d'émission 203, et débouchant sur la face supérieure du substrat de support temporaire 210. Les tranchées 230 délimitent latéralement une pluralité de puces semiconductrices 232 correspondant aux puces élémentaires de pixel du dispositif d'affichage. Les tranchées 230 peuvent être formées par gravure plasma, par sciage, ou par toute autre méthode de découpe adaptée.

Les figures 2F et 2G illustrent une étape de fixation de puces élémentaires 232 sur la face supérieure d'un même substrat de report 250 du dispositif d'affichage. Le substrat de report 250 comprend, du côté de sa face supérieure, une pluralité de plots métalliques de connexion 252, destinés à être fixés et connectés électriquement et mécaniquement à des plots de connexion métalliques correspondants 221 des puces élémentaires 232.

La structure de la figure 2E est retournée (figure 2F) de façon à placer les plots de connexion métalliques 221 de puces élémentaires 232 en vis-à-vis de plots de connexion métalliques 252 correspondants du substrat de report 250. Les plots 221 et 252 en vis-à-vis sont ensuite fixés et connectés électriquement, par exemple par collage direct, par soudure, au moyen de microtubes, ou par toute autre méthode adaptée.

Une fois fixées au substrat de report 250, les puces élémentaires 232 sont détachées du substrat de support temporaire 210, et ce dernier est retiré (figure 2G). A titre d'exemple, le détachage des puces est réalisé par décollement mécanique ou par décollement au moyen d'un faisceau laser.

Dans l'exemple représenté, le pas (distance centre à centre en vue de face) des puces élémentaires 232 sur le substrat de report 250 est un multiple du pas des puces élémentaires 232 sur le substrat. Ainsi, seules une partie des puces élémentaires 232 (une sur deux dans l'exemple représenté) sont transférées simultanément du substrat de support temporaire 210 sur le substrat de report 250. Les autres puces restent attachées au substrat de support temporaire 210 et peuvent être reportées ultérieurement sur une autre partie du substrat de report 250 ou sur un autre substrat de report 250.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et/ou de dimensions mentionnés dans la présente description.

En outre, dans l'exemple décrit en relation avec les figures 1A à 1I, les régions d'anode 113 et les métallisations d'anode 115 des diodes photosensibles sont réalisées après le report de l'empilement actif de diode photosensible 103 sur le circuit intégré de contrôle 151. A titre de variante, non détaillée sur les figures, les régions d'anode 113 et les métallisations d'anode 115 des diodes photosensibles peuvent être réalisées avant le report de l'empilement actif de diode photosensible 103 sur l'empilement actif de LED 113. Dans ce cas, l'ordre des couches de l'empilement 103 est inversé par rapport à l'exemple de la figure 1A. Un avantage est que le recuit d'activation des dopants des régions 113 peut alors être réalisé avant le report de l'empilement 103 sur le circuit intégré 151, ce qui évite toute dégradation du circuit 151 ou du collage entre l'empilement 103 et le circuit 151 lors du recuit.

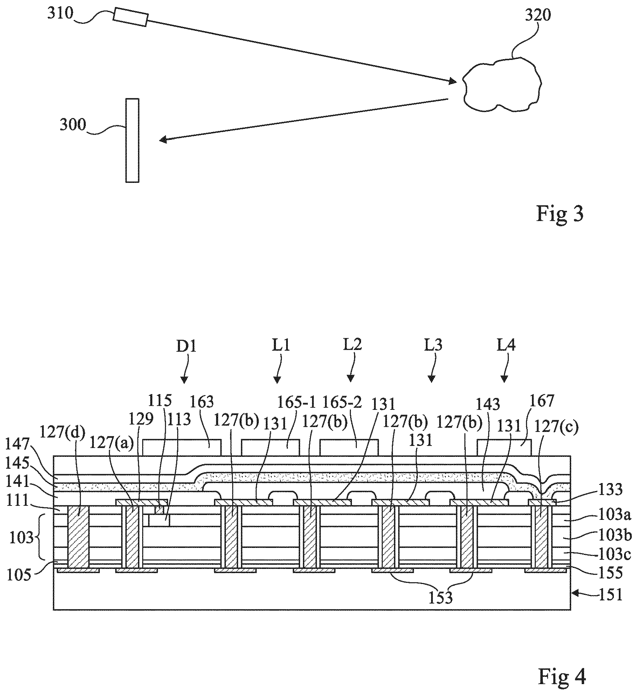

La figure 3 représente de façon schématique un exemple d'un système comprenant un dispositif optoélectronique 300 selon un mode de réalisation.

Le dispositif 300 peut être un dispositif de type micro-écran monolithique, par exemple réalisé par un procédé du type décrit en relation avec les figures 1A à 1I.

A titre de variante, le dispositif 300 peut être un dispositif de plus grandes dimensions, par exemple réalisé par un procédé du type décrit en relation avec les figures 2A à 2G.

Le dispositif 300 combine une fonction d'affichage d'images et une fonction de capture optique, par exemple pour réaliser un écran interactif adapté à mettre en oeuvre des fonctions de reconnaissance de visage ou de formes, de détection de mouvement, d'identification, etc.

Le système de la figure 3 comprend en outre une source lumineuse 310. La source 310 est adaptée à émettre un rayonnement lumineux dans la plage de sensibilité des diodes photosensibles D1 (non détaillées sur la figure 3) du dispositif 300. A titre d'exemple, la source 310 est une source infrarouge, par exemple une source laser.

En fonctionnement, la source 310 éclaire une scène 320 dont on souhaite acquérir une image. La lumière émise par la source 310 est réfléchie par la scène 320 et renvoyée vers le dispositif 300. Les diodes photosensibles D1 du dispositif 300 permettent alors d'acquérir une image de la scène 320 et/ou de mesurer des informations de profondeur relatives à la scène 320.

Dans l'exemple de la figure 3, la source lumineuse 310 est une source déportée, c'est-à-dire qu'elle est distincte du dispositif 300. La commande de la source lumineuse 310 et la commande des pixels de détection du dispositif 300 sont par exemple synchronisées.

La figure 4 est une vue en coupe illustrant de façon schématique et partielle un autre exemple d'un dispositif optoélectronique selon un mode de réalisation.

Dans cet exemple, le dispositif optoélectronique intègre une source lumineuse distribuée émettant dans la gamme de sensibilité des photodiodes D1, par exemple une source infrarouge. Ceci permet de se passer de la source déportée 310 du système de la figure 3.

Le dispositif de la figure 4 comprend des éléments communs avec le dispositif de la figure 1I. Ces éléments ne seront pas détaillés à nouveau ci-après, et seules les différences par rapport au dispositif de la figure 1I seront mises en exergue.

Dans cet exemple, la couche active 143 est une couche d'émission monochromatique. Plus particulièrement, dans cet exemple, la couche active 143 est une couche d'émission de lumière bleue. Les modes de réalisation décrits ne se limitent toutefois pas à cet exemple particulier. La personne du métier saura adapter l'exemple de réalisation décrit en relation avec la figure 4 à d'autres couleurs d'émission de la couche active 143.

Dans l'exemple de la figure 4, l'élément 165-1 est un élément de conversion photoluminescent adapté à convertir la lumière bleue émise par la couche active 143 en lumière rouge, et l'élément 165-2 est un élément de conversion photoluminescent adapté à convertir la lumière bleue émise par la couche active 143 en lumière verte. Dans cet exemple, l'élément 165-3 est omis. Ainsi, les LED L1, L2 et L3 définissent respectivement un pixel d'émission de lumière rouge, un pixel d'émission de lumière verte, et un pixel d'émission de lumière bleue.

Dans l'exemple de la figure 4, le dispositif comprend en outre une quatrième LED organique L4, par exemple identique ou similaire aux LED organiques L1, L2 et L3, commandable individuellement. La LED L4 est surmontée par un élément de conversion photoluminescent 167, adapté à convertir la lumière bleue émise par la couche active 143 en un rayonnement lumineux de longueur d'onde comprise dans la gamme de détection de la diode photosensible D1, par exemple un rayonnement infrarouge.

Ainsi, la LED L4 définit un pixel émissif d'une source lumineuse adaptée à coopérer avec les diodes photosensibles D1 et remplaçant la source 310 du système de la figure 3.

Comme décrit précédemment, le dispositif de la figure 4 peut être un dispositif de type micro-écran monolithique, ou un pixel d'un dispositif de plus grandes dimensions.

Le nombre et le pas de répétition des LED organiques L4 pourra être choisi en fonction des besoins de l'application. Par exemple, on pourra prévoir une LED L4 par pixel d'émission visible, ou une LED L4 par diode photosensible D1, ou une répartition différente. Par exemple, le dispositif peut comprendre moins de LED L4 que de LED visibles L1, L2 ou L3. De préférence, le dispositif final (micro-écran monolithique ou dispositif étendu) comprend plusieurs LED L4 réparties sur la surface du dispositif.

Les éléments de conversion 165-1, 165-2 et 167 surmontant les LED L1 et L2 sont par exemple réalisés à base de boîtes quantiques ou à base de matériaux pérovskites. Les éléments de conversion à base de matériaux pérovskites sont par exemple déposés par dépôt laser pulsé (PLD).

## Revendications

1. Procédé de fabrication d'un dispositif optoélectronique, comportant les étapes successives suivantes :
a) reporter un empilement actif de diode photosensible inorganique (103) sur un circuit intégré de contrôle (151) préalablement formé dans et sur un premier substrat semiconducteur ; et
b) former une pluralité de diodes électroluminescentes organiques (L1, L2, L3 ; L4) sur l'empilement actif de diode photosensible,
dans lequel, à l'issue de l'étape a), l'empilement actif de diode photosensible (103) s'étend de façon continue sur toute la surface du circuit de contrôle (151),
le procédé comprenant en outre, après l'étape a) et avant l'étape b), la formation de vias conducteurs de reprise de contact (127 (a), 127 (b), 127(c), 127(d)) traversant l'empilement actif de diode photosensible (103) et débouchant sur des plots métalliques de connexion (153) du circuit intégré de contrôle (151),
et dans lequel, à l'issue de l'étape b), les diodes électroluminescentes organiques (L1, L2, L3 ; L4) sont connectées au circuit intégré de contrôle (151) par l'intermédiaire desdits vias conducteurs,
dans lequel l'empilement actif de diode photosensible (103) est un empilement de couches semiconductrice inorganiques comprenant des première (103a), deuxième (103b) et troisième (103c) couches semiconductrices inorganiques, la deuxième couche (103b) étant disposée entre les première (103a) et troisième (103c) couches, et la troisième couche (103c) étant disposée du côté du circuit intégré de contrôle (151) à l'issue de l'étape a),
le procédé comprenant une étape de dopage de type P de portions localisées (113) de la première couche (103a), lesdites portions définissant des régions d'anode de diodes photosensibles (D1) du dispositif.

2. Procédé selon la revendication 1, comprenant la formation d'une pluralité de diodes photosensibles (D1) dans l'empilement actif de diode photosensible (103).

3. Procédé selon revendication 1 ou 2, dans lequel, à l'étape a), l'empilement actif de diode photosensible (103) est fixé sur le circuit intégré de contrôle (151) par collage direct d'une couche diélectrique (105) préalablement déposée sur l'empilement actif de diode photosensible (103), avec une couche diélectrique (155) préalablement déposée sur le circuit intégré de contrôle (151).

4. Procédé selon l'une quelconque des revendications 1 à 3, comprenant, après l'étape b), la formation de filtres optiques ou d'éléments de conversion de couleur (165-1, 165-2, 165-3) au-dessus des diodes électroluminescentes organiques (L1, L2, L3 ; L4).

5. Procédé selon la revendication 4 dans son rattachement à la revendication 2, dans lequel lesdites diodes électroluminescentes organiques (L1, L2, L3, L4) sont des diodes monochromatiques de même couleur, au moins une (L1, L2) desdites diode électroluminescentes organiques étant surmontée d'un élément de conversion photoluminescent (165-1, 165-2) adapté à convertir la lumière émise par la diode vers une longueur d'onde visible et au moins une autre (L4) desdites diode électroluminescentes organiques (L4) étant surmontée d'un élément de conversion photoluminescent (167) adapté à convertir la lumière émise par la diode en un rayonnement lumineux dans la gamme de longueurs d'ondes détectée par lesdites diodes photosensibles (D1), de préférence un rayonnement infrarouge.

6. Procédé selon la revendication 5, dans lequel au moins une (L3) desdites diodes électroluminescentes organiques n'est pas surmontée par un élément de conversion photoluminescent.

7. Procédé selon la revendication 4 ou 5, dans lequel lesdites diodes électroluminescentes organiques (L1, L2, L3, L4) sont adaptées à émettre majoritairement de la lumière bleue.

8. Procédé selon l'une quelconque des revendications 5 à 7, dans lequel lesdits éléments de conversion photoluminescents (165-1, 165-2, 167) sont réalisés à base de boîtes quantiques ou de matériaux pérovskites.

9. Procédé selon l'une quelconque des revendications 1 à 8, dans lequel l'empilement actif de diode photosensible (103) comprend au moins une couche semiconductrice en un matériau III-V.

10. Procédé selon l'une quelconque des revendications 1 à 9, dans lequel ladite étape de dopage de type P de portions localisées (113) de la première couche (103a) est mise en oeuvre après l'étape a) et avant l'étape b).

11. Procédé selon la revendication 10, comprenant en outre, après ladite étape de dopage de type P de portions localisées (113) de la première couche (103a) et avant l'étape b), une étape de formation de métallisations de connexion (115) sur et en contact avec lesdites portions localisées (113) de la première couche (103a).

12. Procédé selon l'une quelconque des revendications 1 à 11, comportant, après l'étape b), une étape de fixation d'un substrat de support temporaire (210) du côté d'une face du dispositif opposée au circuit intégré (151), suivie d'une étape de découpe de l'ensemble comportant le circuit intégré (151), l'empilement actif de diode photosensible (103) et les diodes électroluminescentes organiques (L1, L2, L3 ; L4) en une pluralité de puces élémentaires (232).

13. Procédé selon la revendication 12, comportant en outre une étape de transfert et de fixation desdites puces élémentaire (232) sur un substrat de report (250) du dispositif, puis une étape de retrait du substrat de support temporaire (210).

14. Dispositif d'affichage comportant un substrat de report (250), et une pluralité de puces élémentaires (232) fixées et connectées électriquement au substrat de report (250), chaque puce élémentaire (232) comprenant un dispositif optoélectronique comprenant :
un circuit intégré de contrôle (151) formé dans et sur un premier substrat semiconducteur et un empilement actif de diode photosensible inorganique (103) disposé sur le circuit intégré de contrôle (151), l'empilement actif de diode photosensible inorganique s'étendant de façon continue sur toute la surface du circuit de contrôle ;
une pluralité de diodes électroluminescentes organiques (L1, L2, L3 ; L4) disposées sur l'empilement actif de diode photosensible ;
des vias conducteurs de reprise de contact (127(a), 127(b), 127(c), 127(d)) traversant l'empilement actif de diode photosensible (103) et débouchant sur des plots métalliques de connexion (153) du circuit intégré de contrôle (151), les diodes électroluminescentes organiques (L1, L2, L3 ;
L4) étant connectées au circuit intégré de contrôle (151) par l'intermédiaire desdits vias conducteurs,
dans lequel l'empilement actif de diode photosensible (103) est un empilement de couches semiconductrice inorganiques comprenant des première (103a), deuxième (103b) et troisième (103c) couches semiconductrices inorganiques, la deuxième couche (103b) étant disposée entre les première (103a) et troisième (103c) couches, la troisième couche (103c) étant disposée du côté du circuit intégré de contrôle (151), et la première couche (103a) comprenant des portions localisées (113) dopées de type P définissant des régions d'anode de diodes photosensibles (D1),
le circuit intégré de contrôle (151) de chaque puce élémentaire (232) étant disposé du côté du substrat de report (250).

15. Système comportant un dispositif d'affichage (300) selon la revendication 14, et une source lumineuse adaptée à émettre un rayonnement lumineux dans la gamme de longueurs d'ondes détectée par lesdites diodes photosensibles inorganiques (D1), de préférence un rayonnement infrarouge.

16. Système selon la revendication 15, dans lequel la source lumineuse est une source déportée (310).

17. Système selon la revendication 15, dans lequel la source lumineuse est intégrée au dispositif d'affichage (300) et comprend au moins une diode électroluminescente organique (L4) d'une puce élémentaire (232) du dispositif d'affichage (300).

## Patentansprüche

1. Verfahren zur Herstellung einer optoelektronischen Vorrichtung, das die folgenden aufeinanderfolgenden Schritte aufweist:
a) Übertragen eines aktiven anorganischen lichtempfindlichen Diodenstapels (103) auf eine integrierte Steuerschaltung (151), die zuvor innerhalb und auf einem ersten Halbleitersubstrat ausgebildet wurde; und
b) Ausbilden einer Vielzahl von organischen Leuchtdioden (L1, L2, L3; L4) auf dem aktiven lichtempfindlichen Diodenstapel,
wobei sich am Ende von Schritt a) der aktive lichtempfindliche Diodenstapel (103) kontinuierlich über die gesamte Oberfläche der Steuerschaltung (151) erstreckt,
wobei das Verfahren ferner nach Schritt a) und vor Schritt b) das Ausbilden von leitfähigen Durchkontaktierungen (127(a), 127(b), 127(c), 127(d)) aufweist, die den aktiven lichtempfindlichen Diodenstapel (103) kreuzen und auf Metallverbindungsflächen (153) der integrierten Steuerschaltung (151) austreten,
und wobei am Ende von Schritt b) die organischen Leuchtdioden (L1, L2, L3; L4) über die leitfähigen Durchkontaktierungen mit der integrierten Steuerschaltung (151) verbunden sind,
der aktive lichtempfindliche Diodenstapel (103) ein Stapel aus anorganischen Halbleiterschichten ist, der eine erste (103a), zweite (103b) und dritte (103c) anorganische Halbleiterschicht aufweist, wobei die zweite Schicht (103b) zwischen der ersten (103a) und der dritten (103c) Schicht angeordnet ist und die dritte Schicht (103c) am Ende von Schritt a) auf der Seite der integrierten Steuerschaltung (151) angeordnet ist,
wobei das Verfahren einen Schritt des P-Typ-Dotierens lokalisierter Bereiche (113) der ersten Schicht (103a) aufweist, wobei die Bereiche Anodenbereiche von lichtempfindlichen Dioden (D1) der Vorrichtung definieren.

2. Verfahren nach Anspruch 1, aufweisend das Bilden einer Vielzahl von lichtempfindlichen Dioden (D1) in dem aktiven lichtempfindlichen Diodenstapel (103).

3. Verfahren nach Anspruch 1 oder 2, wobei in Schritt a) der aktive lichtempfindliche Diodenstapel (103) an der integrierten Steuerschaltung (151) befestigt wird, durch direktes Bonden einer zuvor auf dem aktiven lichtempfindlichen Diodenstapel (103) abgeschiedene dielektrische Schicht (105) mit einer zuvor auf der integrierten Steuerschaltung (151) abgeschiedenen dielektrischen Schicht (155).

4. Verfahren nach einem der Ansprüche 1 bis 3, aufweisend nach Schritt b) das Ausbilden von optischen Filtern oder von Farbkonversionselementen (165-1, 165-2, 165-3) über den organischen Leuchtdioden (L1, L2, L3; L4).

5. Verfahren nach Anspruch 4, abhängig von Anspruch 2, wobei die organischen Leuchtdioden (L1, L2, L3, L4) monochromatische Dioden derselben Farbe sind, wobei mindestens eine (L1, L2) der organischen Leuchtdioden mit einem photolumineszierenden Umwandlungselement (165-1, 165-2) bedeckt ist, das dazu ausgelegt ist, das von der Diode emittierte Licht in eine sichtbare Wellenlänge umzuwandeln, und wobei mindestens eine weitere (L4) der organischen Leuchtdioden (L4) mit einem photolumineszierenden Umwandlungselement (167) bedeckt ist, das dazu ausgelegt ist, das von der Diode emittierte Licht in eine andere sichtbare Wellenlänge um , das dazu ausgelegt ist, das von der Diode emittierte Licht in Lichtstrahlung in dem Wellenlängenbereich, der von den lichtempfindlichen Dioden (D1) erfasst wird, umzuwandeln, vorzugsweise in eine Infrarotstrahlung.

6. Verfahren nach Anspruch 5, wobei mindestens eine (L3) der organischen Leuchtdioden nicht mit einem photolumineszierenden Umwandlungselement versehen ist.

7. Verfahren nach Anspruch 4 oder 5, wobei die organischen Leuchtdioden (L1, L2, L3, L4) so ausgelegt sind, dass sie hauptsächlich blaues Licht emittieren.

8. Verfahren nach einem der Ansprüche 5 bis 7, wobei die photolumineszierenden Umwandlungselemente (165-1, 165-2, 167) auf der Basis von Quantenpunkten oder Perowskit-Materialien aufgebaut sind.

9. Verfahren nach einem der Ansprüche 1 bis 8, wobei der aktive lichtempfindliche Diodenstapel (103) mindestens eine Halbleiterschicht aus einem III-V-Material aufweist.

10. Verfahren nach einem der Ansprüche 1 bis 9, wobei der Schritt des P-Typ-Dotierens lokaler Bereiche (113) der ersten Schicht (103a) nach Schritt a) und vor Schritt b) durchgeführt wird.

11. Verfahren nach Anspruch 10, das nach dem Schritt des P-Typ-Dotierens lokaler Bereiche (113) der ersten Schicht (103a) und vor Schritt b) einen Schritt des Bildens von Verbindungsmetallisierungen (115) auf und in Kontakt mit den lokalen Bereichen (113) der ersten Schicht (103a) aufweist.

12. Verfahren nach einem der Ansprüche 1 bis 11, das nach Schritt b) einen Schritt des Bondens eines temporären Trägersubstrats (210) auf der Seite einer Oberfläche der Vorrichtung, die der integrierten Schaltung (151) gegenüberliegt, aufweist, gefolgt von einem Schritt des Schneidens der Anordnung, die die integrierte Schaltung (151), den aktiven lichtempfindlichen Diodenstapel (103) und die organischen Leuchtdioden (L1, L2, L3; L4) in eine Vielzahl von Elementarchips (232).

13. Verfahren nach Anspruch 12, das ferner einen Schritt des Übertragens und Verbindens der Elementarchips (232) auf ein Transfersubstrat (250) der Vorrichtung aufweist, gefolgt von einem Schritt des Entfernens des temporären Trägersubstrats (210).

14. Anzeigevorrichtung, die ein Transfersubstrat (250) und mehrere Elementarchips (232) aufweist, die auf das Transfersubstrat (250) gebondet und elektrisch mit diesem verbunden sind, wobei jeder Elementarchip (232) eine optoelektronische Vorrichtung aufweist, die Folgendes aufweist:
eine integrierte Steuerschaltung (151), die in und auf einem ersten Halbleitersubstrat ausgebildet ist, und einen aktiven anorganischen lichtempfindlichen Diodenstapel (103), der auf der integrierten Steuerschaltung (151) angeordnet ist, wobei sich der aktive anorganische lichtempfindliche Diodenstapel kontinuierlich über die gesamte Oberfläche der integrierten Steuerschaltung erstreckt;
eine Vielzahl von organischen Leuchtdioden (L1, L2, L3; L4), die auf dem aktiven lichtempfindlichen Diodenstapel angeordnet sind;
leitfähige Durchkontaktierungen (127(a), 127(b), 127(c), 127(d)), die durch den aktiven lichtempfindlichen Diodenstapel (103) verlaufen und zu Metallverbindungsflächen (153) der integrierten Steuerschaltung (151) führen, wobei die organischen Leuchtdioden (L1, L2, L3; L4) über die leitfähigen Durchkontaktierungen mit der integrierten Steuerschaltung (151) verbunden sind,
wobei der aktive lichtempfindliche Diodenstapel (103) ein Stapel aus anorganischen Halbleiterschichten ist, der eine erste (103a), eine zweite (103b) und eine dritte (103c) anorganische Halbleiterschicht aufweist, wobei die zweite Schicht (103b) zwischen der ersten (103a) und der dritten (103c) Schicht angeordnet ist, die dritte Schicht (103c) auf der Schaltungsseite (151) angeordnet ist und die erste Schicht (103a) lokalisierte P-Typ-dotierte Abschnitte (113) aufweist, die lichtempfindliche Diodenanodenbereiche (D1) definieren,
wobei die integrierte Steuerschaltung (151) jedes Elementarchips (232) auf der Seite des Transfersubstrats (250) angeordnet ist.

15. System, das eine Anzeigevorrichtung (300) gemäß Anspruch 14 und eine Lichtquelle aufweist, die dazu ausgelegt ist, eine Lichtstrahlung im Wellenlängenbereich zu emittieren, der von den anorganischen lichtempfindlichen Dioden (D1) erfasst wird, vorzugsweise eine Infrarotstrahlung.

16. System gemäß Anspruch 15, wobei die Lichtquelle eine entfernte Quelle (310) ist.

17. System gemäß Anspruch 15, wobei die Lichtquelle in die Anzeigevorrichtung (300) integriert ist und mindestens eine organische Leuchtdiode (L4) eines Elementarchips (232) der Anzeigevorrichtung (300) aufweist.

## Claims

1. Optoelectronic device manufacturing method, comprising the successive steps of:
a) transferring an active inorganic photosensitive diode stack (103) onto an integrated control circuit (151) previously formed inside and on top of a first semiconductor substrate; and
b) forming a plurality of organic light-emitting diodes (L1, L2, L3; L4) on the active photosensitive diode stack,
wherein, at the end of step a), the active photosensitive diode stack (103) continuously extends over the entire surface of the control circuit (151), the method further comprising, after step a) and before step b), the forming of conductive contacting vias (127(a), 127(b), 127(c), 127(d)) crossing the active photosensitive diode stack (103) and emerging onto metal connection pads (153) of the integration control circuit (151),
and wherein, at the end of step b), the organic light-emitting diodes (L1, L2, L3; L4) are connected to the integrated control circuit (151) via said conductive vias,
wherein the active photosensitive diode stack (103) is a stack of inorganic semiconductor layers comprising first (103a), second (103b), and third (103c) inorganic semiconductor layers, the second layer (103b) being arranged between the first (103a) and third (103c) layers, and the third layer (103c) being arranged on the side of the integrated control circuit (151) at the end of step a),
the method comprising a step of P-type doping of localized portions (113) of the first layer (103a), said portions defining anode regions of photosensitive diodes (D1) of the device.

2. Method according to claim 1, comprising the forming of a plurality of a photosensitive diodes (D1) in the active photosensitive diode stack (103).

3. Method according to claim 1 or 2, wherein, at step a), the active photosensitive diode stack (103) is fixed to the integrated control circuit (151) by direct bonding of a dielectric layer (105) previously deposited on the active photosensitive diode stack (103), with a dielectric layer (155) previously deposited on the integrated control circuit (151).

4. Method according to any of claims 1 to 3, comprising, after step b), the forming of optical filters or of color conversion elements (165-1, 165-2, 165-3) above the organic light-emitting diodes (L1, L2, L3; L4).

5. Method according to claim 4 depending from claim 2, wherein said organic light-emitting diodes (L1, L2, 13, L4) are monochromatic diodes of same color, at least one (L1, L2) of said organic light-emitting diodes being topped with a photoluminescent conversion element (165-1, 165-2) adapted to converting the light emitted by the diode into a visible wavelength and at least another one (L4) of said organic light-emitting diodes (L4) being topped with a photoluminescent conversion element (167) adapted to converting the light emitted by the diode into a light radiation in the wavelength range detected by said photosensitive diodes (D1), preferably an infrared radiation.

6. Method according to claim 5, wherein at least one (L3) of said organic light-emitting diodes is not topped with a photoluminescent conversion element.

7. Method according to claim 4 or 5, wherein said organic light-emitting diodes (L1, L2, L3, L4) are adapted to mainly emitting blue light.

8. Method according to any of claims 5 to 7, wherein said photoluminescent conversion elements (165-1, 165-2, 167) are formed based on quantum dots or on perovskite materials.

9. Method according to any of claims 1 to 8, wherein the active photosensitive diode stack (103) comprises at least one semiconductor layer made of a III-V material.

10. Method according to any of claims 1 to 9, wherein said step of P-type doping of local portions (113) of the first layer (103a) is implemented after step a) and before step b).

11. Method according to claim 10, further comprising, after said step of P-type doping of local portions (113) of the first layer (103a) and before step b), a step of forming of connection metallizations (115) on top of and in contact with said local portions (113) of the first layer (103a).

12. Method according to any of claims 1 to 11, comprising, after step b), a step of bonding of a temporary support substrate (210) onto the side of a surface the device opposite to the integrated circuit (151), followed by a step of cutting of the assembly comprising the integrated circuit (151), the active photosensitive diode stack (103), and the organic light-emitting diodes (L1, L2, L3; L4) into a plurality of elementary chips (232).

13. Method according to claim 12, further comprising a step of transfer and of bonding of said elementary chips (232) onto a transfer substrate (250) of the device, followed by a step of removal of the temporary support substrate (210).

14. Display device comprising a transfer substrate (250) and a plurality of elementary chips (232) bonded and electrically connected to the transfer substrate (250), each elementary chip (232) comprising an optoelectronic device comprising:
an integrated control circuit (151) formed in and on a first semiconductor substrate and an active inorganic photosensitive diode stack (103) disposed on the integrated control circuit (151), the active inorganic photosensitive diode stack extending continuously over the entire surface of the integrated control circuit;
a plurality of organic light-emitting diodes (L1, L2, L3; L4) arranged on the active photosensitive diode stack;
conductive contact vias (127(a), 127(b), 127(c), 127(d)) passing through the active photosensitive diode stack (103) and leading to metal connection pads (153) of the integrated control circuit (151), organic light-emitting diodes (L1, L2, L3; L4) being connected to the integrated control circuit (151) via said conductive vias,
wherein the active photosensitive diode stack (103) is a stack of inorganic semiconductor layers comprising first (103a), second (103b) and third (103c) inorganic semiconductor layers, the second layer (103b) being disposed between the first (103a) and third (103c) layers, the third layer (103c) being disposed on the circuit side (151), and the first layer (103a) comprising localized P-type doped portions (113) defining photosensitive diode (D1) anode regions,
the integrated control circuit (151) of each elementary chip (232) being arranged on the side of the transfer substrate (250).

15. System comprising a display device (300) according to claim 14, and a light source adapted to emitting a light radiation in the wavelength range detected by said inorganic photosensitive diodes (D1), preferably an infrared radiation.

16. System according to claim 15, wherein the light source is a remote source (310).

17. System according to claim 15, wherein the light source is integrated to the display device (300) and comprises at least one organic light-emitting diode (L4) of an elementary chip (232) of the display device (300).
